# EUROPÄISCHE PATENTANMELDUNG

(11) **EP 0 782 004 A1**
(43) Veröffentlichungstag der Anmeldung: **02.07.1997**
(21) Anmeldenummer: 95810820.1
(22) Anmeldetag: 27.12.1995
(51) Int. Cl.: G01R 33/30

(54) **Untersuchungsverfahren mittels Kernspinresonanz**

(71) Anmelder: CIBA-GEIGY AG, 4002 Basel (CH)
(72) Erfinder: Jahnke,Wolfgang Dr, 79594 Inzlingen (DE)

(57) **Zusammenfassung**

Bei einem kernmagnetischen Untersuchungsverfahren mittels Kernspinresonanz wird eine zu untersuchende Probe in den Innenraum einer Spule (2) eingebracht, so dass zumindest Teile der Probe von der Spule (2) umgeben werden und somit ein aktives Probenvolumen (4a;4b) bilden. Die Probe wird in ein externes Magnetfeld (B₀) eingebracht. Kernspins von in der Probe enthaltenen Atomkernen werden durch ein von der Spule (2) erzeugtes hochfrequentes elektromagnetisches Wechselfeld (B₁) zu kernmagnetischer Resonanz angeregt. Von der Probe werden höchstens neunzig Prozent des Innenraums der Spule (2) besetzt. Der Rest des Innenraums der Spule (2) ist mit einem Material gefüllt, dessen magnetische Suszeptibilität an die magnetische Suszeptibilität der Probe angepasst ist.

## Beschreibung

Die Erfindung betrifft ein kernmagnetisches Untersuchungsverfahren mittels Kernspinresonanz gemäss dem Oberbegriff des unabhängigen Patentanspruchs. Gemäss der allgemein üblichen Nomenklatur wird der Begriff "Kernspinresonanz" im folgenden mit der von dem englischen Begriff "Nuclear Magnetic Resonance" stammenden Abkürzung NMR bezeichnet.

Die NMR ist eine wohl etablierte, hochentwickelte spektroskopische Untersuchungsmethode, die unter anderem in zahlreichen Gebieten der chemischen, physikalischen und biologischen Forschung und Analytik, beispielsweise zur Strukturanalyse, eingesetzt wird. Auch in der medizinischen Diagnostik und der medizinischen Forschung findet die NMR heute in Form eines bildgebenden, nicht-invasiven Untersuchungsverfahrens breite Anwendungen. Prinzipiell basiert die NMR auf der Wechselwirkung zwischen den mit dem Kernspin der Atome verbundenen magnetischen Dipolmoment der Kerne und magnetischen Feldern. Die NMR und speziell ihre Grundlagen sind in zahlreichen Lehrbüchern, wie beispielsweise *Principles of Magnetic Resonance*, (3rd ed., Springer 1990) von C. P. Slichter beschrieben.

Zur Abklärung der im folgenden verwendeten Terminologie wird nun beispielhaft ein sehr einfaches Experiment der NMR-Impulsspektrometrie beschrieben. Eine Probe wird in ein statisches, homogenes Magnetfeld gebracht, das konventionsgemäss die z-Richtung eines kartesischen Koordinatensystems definiert. Dies führt zu einer Ausrichtung der magnetischen Dipolmomente, welche mit den Kernspins der in der Probe enthaltenen Atomkerne verbundenen sind, so dass im thermodynamischen Gleichgewicht eine makroskopische Kernmagnetisierung in Richtung der z-Achse des Koordinatensystems existiert. Die Probe wird von einer Spule umgeben, die ein hochfrequentes elektromagnetisches Wechselfeld erzeugt, dessen Richtung üblicherweise in der x-y-Ebene des Koordinatensystems, also senkrecht zum statischen Magnetfeld, liegt. Die Frequenz dieses Wechselfeldes, das im folgenden als RF-Feld bezeichnet wird, liegt im Bereich der Resonanzfrequenz der Kernspins. Typischerweise liegen diese Frequenzen im Radiofrequenz (RF-) Bereich von bis zu einigen hundert Megahertz. Dieses RF-Feld, das typischerweise in Form eines Impulses möglichst genau definierter Länge, des sogenannten RF-Impulses, in die Probe eingestrahlt wird, regt die Kernspins zur Resonanz an und führt makroskopisch gesehen zu einer Drehung der Kernmagnetisierung aus ihrer momentanen Lage um einen Winkel, dessen Grösse von der Zeitdauer des RF-Impulses, der Stärke des elektromagnetischen Wechselfeldes und dem gyromagnetischen Verhältnis, welches eine kernspezifische Konstante ist, abhängt. Es ist allgemein üblich, den RF-Impuls nach dem durch ihn bewirkten Auslenkwinkel zu benennen. Ist die Kernmagnetisierung z. B. vor dem Impuls entlang der z-Achse ausgerichtet, so dreht ein 90°-Impuls die Kernmagnetisierung in die x-y-Ebene. Die Kernmagnetisierung präzediert um die Richtung des statischen Magnetfeldes, also die z-Achse, und ihre in der x-y-Ebene rotierende Komponente induziert in der auch als Empfänger dienenden Spule eine Spannung, welche als Signal erfasst wird und zur Erstellung eines NMR-Spektrums dient.

Mit der heutigen Technologie ist es möglich, RF-Impulse oder eine Folge solcher Impulse zu kreieren, mit denen einerseits eine spezifische Kernart so zur Resonanz angeregt wird, dass sie einen möglichst grossen Beitrag zum detektierten Signal liefert. Andererseits ist es aber auch möglich, Kernarten gezielt so anzuregen, dass sie möglichst keinen Beitrag zum detektierten Signal liefern. Der Begriff "Kernart" ist hier und im folgenden so zu verstehen, dass Kerne, welche zur selben Kernart gehören, zum einen Kerne desselben chemischen Elements sind und zum anderen in der Probe die gleiche atomare oder molekulare Umgebung haben. Mit dieser Begriffsfestlegung gehören beispielsweise Wasserstoff-Kerne, die an einen Sauerstoff-Kern gebunden sind, einer andern Kernart an als solche, die an einen Kohlenstoff-Kern gebunden sind.

Bezüglich der modernen hochauflösenden NMR-Impulsspektrometrie ist dem Fachmann eine grosse Anzahl von unterschiedlichen Arten von NMR-Untersuchungen bekannt, wie beispielsweise ein- und mehrdimensionale NMR, Single-Resonanz, Doppel-Resonanz oder Tripel-Resonanz. Noch zahlreicher sind die unterschiedlichen, zum Teil sehr komplexen, RF-Impulsfolgen, die bei solchen Untersuchungen eingesetzt werden. Oft werden auch mehrere, sukzessive aufgezeichneten Spektren addiert bzw. subtrahiert, um daraus die gewünschte Messgrösse zu extrahieren.

Die zu untersuchende Probe kann sich zum Beispiel in einem Probenröhrchen, dessen Längsachse parallel zur z-Achse liegt, befinden. Ein Teil des Probenröhrchens, und damit der Probe, wird von der Spule zur Erzeugung des RF-Feldes umgeben. Dieser von der Spule umgebene Teil der Probe wird im folgenden als das aktive Probenvolumen bezeichnet. Die Spule kann das aktive Probenvolumen beispielsweise in Form der bekannten Helmholtz-Anordnung umgeben. Speziell in der hochauflösenden NMR ist es eine gängige Praxis, das mit der Probe gefüllte Probenröhrchen so zu plazieren, dass die Probe in z-Richtung deutlich über die Enden der Spule hinaus reicht, das gesamte Probenvolumen mithin wesentlich grösser ist als das aktive Probenvolumen. Diese Massnahme bringt den Vorteil mit sich, dass im Bereich der Spule, also dort, wo das RF-Feld erzeugt wird, und insbesondere im Gebiet der beiden Enden der Spule bezüglich der z-Achse, starke Änderungen oder Sprünge in der magnetischen Suszeptibilität vermieden werden. Solche Änderungen oder Sprünge würden sich sehr nachteilig auf die Signalqualität, speziell die Linienformen der Resonanzlinien, auswirken.

Ein grosses Problem bei vielen NMR-Untersuchungen liegt darin begründet, dass das RF-Feld über das gesamte aktive Probenvolumen räumlich nicht ausreichend homogen ist, also die Stärke des RF-Feldes an unterschiedlichen Orten des aktiven Probenvolumens verschieden ist. Idealerweise sollte die Stärke des RF-Feldes als Funktion der z-Koordinate eine Rechteckfunktion sein, die bei der minimalen z-Koordinate des aktiven Probenvolumens von Null auf einen bestimmten Wert springt, diesen Wert bis zur maximalen z-Koordinate des aktiven Probenvolumens beibehält und dort wiederum auf Null springt. Eine solche ideale Rechteckform lässt sich jedoch physikalisch nicht realisieren. In der Praxis sieht es deshalb so aus, dass das RF-Feld etwa im bezüglich der z-Achse mittleren Bereich des aktiven Probenvolumens seine maximale Stärke aufweist und von dort in Richtung zu- und abnehmender z-Koordinate des Probenortes abnimmt, wobei der stärkste Abfall in den Bereichen der Probe liegt, die nicht mehr zum aktiven Probenvolumen gehören, also ausserhalb des von der Spule umgebenen Bereiches. Es sind bereits grosse Anstrengungen unternommen worden, die Homogenität des RF-Feldes über das gesamte Probenvolumen zu verbessern. Insbesondere durch spezielle Ausgestaltungen der Spule versucht man, die ideale Rechteckfunktion für das RF-Feld möglichst gut zu approximieren. Bei solchen Optimierungen werden immer zwei Aspekte berücksichtigt: Zum einen muss das RF-Feld über das gesamte aktive Probenvolumen räumlich möglichst konstant gehalten werden und zum andern muss das RF-Feld an den Grenzen des aktiven Probenvolumens möglichst steil abfallen. Die heute bekannten technischen Realisierungen von solchen Spulen stellen typischerweise stets einen Kompromiss zwischen diesen beiden Aspekten dar.

Daher kommt es, dass die Stärke des RF-Feldes an den Grenzen des aktiven Probenvolumens bezüglich der z-Achse oftmals bereits erheblich von dem maximalen Wert abweicht. Dies hat die äusserst nachteilige Folge, dass der Drehwinkel, um welchen die Kermagnetisierung durch den RF-Impuls ausgelenkt wird, nicht mehr für alle Bereiche des aktiven Probenvolumens seinen nominellen Wert hat. So dürfte beispielsweise nach einem idealen 180°-Impuls, der auf die ursprünglich in positiver z-Richtung ausgerichtete Kernmagnetisierung einwirkt und der diese in die negative z-Richtung drehen sollte, kein Signal beobachtbar sein. Da aber ein solcher Impuls in der Realität durch die mangelnde räumliche Homogenität, beispielsweise im Grenzbereich der Spule, seinen nominellen Wert nicht mehr erreicht und nur noch einen Drehwinkel realisiert, der deutlich kleiner als 180° ist, resultiert von diesen Bereichen ein noch detektierbares Signal. Speziell bei komplexen Impulsfolgen führen diese Effekte, auch durch Akkumulation, sehr häufig zu Artefakten, womit Signale gemeint sind, die im Falle idealer Impulse nicht auftreten würden. Solche Artefakte, die in der Regel nicht von dem "wahren" Signal unterscheidbar sind, können sehr leicht zu Fehlinterpretationen der Messungen führen und stellen heutzutage eine der begrenzenden Faktoren für die Möglichkeiten der modernen hochauflösenden NMR dar. Das Problem solcher Artefakte wird beispielsweise auch von G. Wider *et al.* in *Journal of the American Chemical Society, 112 , 9015-9016 (1990)* beschrieben.

Ebenfalls negativ wirkt sich die mangelnde räumliche Homogenität des RF-Feldes auch auf die Empfindlichkeit von NMR-Untersuchungen aus, weil eine optimale Resonanzanregung aller Kernspins des aktiven Probenvolumens nicht mehr gewährleistet ist.

Es besteht daher ein klares Bedürfnis, die räumliche Homogenität des RF-Feldes über das gesamte Probenvolumen, welches zum Signal beiträgt, bei NMR-Untersuchungen deutlich zu steigern. R. E. Hurd *et al.* schlagen in ihrem Artikel im *Journal of Magnetic Resonance, 99, 632-637 (1992)* zur Lösung dieser Problematik vor, vor der eigentlichen NMR-Untersuchung durch speziell geformte RF-Impulse und spezielle Gradienten-Impulse die Randbereiche des aktiven Probenvolumens bezüglich der z-Achse selektiv anzuregen und in der Folge diese Signale durch Gradienten-Dephasierung zu eliminieren. Diese Methode hat jedoch den Nachteil, dass jedes NMR-Experiment eine zusätzliche spezielle Vorbereitung erfordert, was den zeitlichen Gesamtaufwand deutlich erhöht. Ausserdem sind zur Erzeugung der speziellen RF-Impulse bzw. der Gradientenimpulse zusätzliche Spulen und in nicht unerheblichem Masse zusätzliche Auswerte- und Steuervorrichtungen vonnöten, wodurch sich der Gesamtaufwand für die NMR-Untersuchungen auch instrumentell signifikant erhöht.

Es ist daher eine Aufgabe der Erfindung, ein Verfahren für NMR-Untersuchungen vorzuschlagen, mit dem eine deutliche Verbesserung der räumlichen Homogenität des RF-Feldes über das gesamte aktive Probenvolumen erreicht wird. Das Verfahren soll einfach in der Durchführung sein, sowie ohne grossen zusätzlichen zeitlichen und instrumentellen Aufwand durchführbar sein. Ausserdem soll sich das Verfahren für möglichst viele der heute bekannten Arten von NMR-Untersuchungen, speziell auch für solche mit komplexen Impulsfolgen, eignen.

Das diese und noch andere Aufgaben lösende kernmagnetische Untersuchungsverfahren mittels Kernspinresonanz ist durch die Merkmale des unabhängigen Anspruchs gekennzeichnet.

Weitere vorteilhafte Massnahmen und bevorzugte Ausgestaltungen ergeben sich aus den abhängigen Ansprüchen.

Im folgenden wird die Erfindung anhand von Ausführungsbeispielen und anhand der Zeichnung näher erläutert. In der schematischen, nicht massstäblichen Zeichnung zeigen:
- Fig. 1:: eine stark schematisierte Schnittdarstellung einer Spule und eines Probenröhrchens mit Probe für NMR-Untersuchungen,
- Fig. 2:: eine Schnittdarstellung des Probenröhrchens aus Fig. 1 und eines Probenbehälters, der für das erfindungsgemässe Verfahren geeignet ist, sowie eine Graphik mit der Verteilung der Stärke des RF-Feldes,
- Fig. 3: zwei Diagramme, die jeweils die Signalintensität als Funktion der Zeitdauer des RF-Impulses zeigen, und
- Fig.4: zwei Diagramme analog zu Fig. 3, jedoch für eine andere Untersuchung.

Zur Durchführung des erfindungsgemässen Verfahrens sind beispielsweise an sich bekannte und in verschiedenartigen Ausführungen kommerziell erhältliche NMR-Spektrometer mit ebenfalls an sich bekannten und kommerziell erhältlichen Magnetsystemen zur Erzeugung eines statischen Magnetfeldes geeignet. Die gesamte Technologie, insbesondere die mechanische und elektronische Ausgestaltung des Magnetsystems sowie des NMR-Spektrometers inklusive der benötigten Auswerte- und Weiterverarbeitungsmittel sind zum einen dem Fachmann vom Stand der Technik her hinreichend bekannt und zum anderen nicht Gegenstand dieser Erfindung. Auf solche apparativen Aspekte wird daher nur im Rahmen des für das Verständnis der Erfindung Notwendigen eingegangen. Mit rein beispielhaftem Charakter sei hier als ein für die Durchführung des erfindungsgemässen Verfahrens geeignetes NMR-Spektrometer dasjenige genannt, welches von der Firma Varian Associates Inc. (Palo Alto, California, USA) unter der Typenbezeichnung 600 MHz UnityPlus vertrieben wird. Probenköpfe mit darin integrierten Spulen sind von der gleichen Firma erhältlich. Dieses Spektrometer kann beispielsweise in Verbindung mit einem Magnetsystem vom Typ Oxford 600/51 Superconducting Magnet System, wie es von der Firma Oxford Instruments Limited (Oxford England) erhältlich ist, betrieben werden.

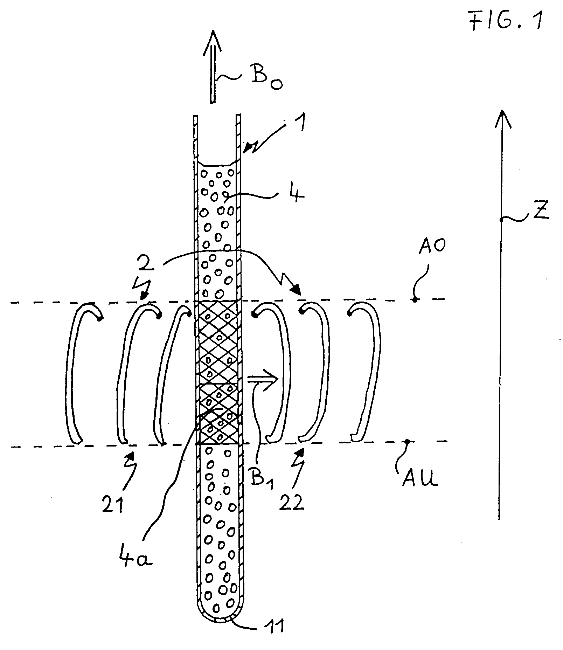

Typischerweise wird bei einem kernmagnetischen Untersuchungsverfahren mittels Kernspinresonanz - im folgenden mit NMR abgekürzt - eine zu untersuchende Probe 4 (Fig. 1) in den Innenraum einer Spule 2 eingebracht, so dass zumindest Teile der Probe von der Spule umgeben werden. Diese Spule dient zum einen der Erzeugung eines hochfrequenten elektromagnetischen Wechselfeldes B₁ - im folgenden als RF-Feld B₁ bezeichnet -, mit welchem Kernspins von in der Probe enthaltenen Atomkernen zur kernmagnetischen Resonanz angeregt werden, und zum anderen der Detektion des Signals. Üblicherweise ist die Spule 2 in einen Probenkopf zur Aufnahme der Probe 4 integriert. Die Probe 4 wird zusammen mit der Spule 2 in ein externes, statisches und homogenes Magnetfeld B₀ eingebracht, mit welchem die Kernspins ausgerichtet werden.

Fig. 1 zeigt in einer sehr schematischen Schnittdarstellung ein Beispiel für eine Anordnung von der Probe 4 und der Spule 2, wie sie häufig für hochauflösende NMR-Untersuchungen eingesetzt wird. Die Darstellung der Spule 2 ist in dieser Figur symbolisch zu verstehen. Der allgemein üblichen Konvention folgend, definiert die Richtung des externen Magnetfeldes B₀, welches in Fig. 1 symbolisch durch den mit dem Bezugszeichen B₀ versehenen Pfeil angedeutet ist, die z-Achse Z eines kartesischen Koordinatensystems. Die Probe 4 liegt hier in flüssiger Form vor. Häufig werden die zu untersuchenden Moleküle oder Teilchen in Wasser oder deuteriertem Wasser gelöst. Unter "Probe" wird fortan die Gesamtheit aus Lösungsmittel und den darin enthaltenen Teilchen verstanden. Die Probe 4 befindet sich in einem Probenröhrchen 1, dessen Längsachse parallel zur z-Achse Z ausgerichtet ist. Dieses Probenröhrchen 1 mit der darin enthaltenen Probe 4 reicht durch den Innenraum der Spule 2. Der Begriff "Innenraum der Spule" ist so zu verstehen, dass er dasjenige von der Spule 2 umgebene Gebiet bezeichnet, in dem das von der Spule 2 erzeugte Feld hauptsächlich, das heisst ausschliesslich eventuell vorhandener Streufelder, existiert. In dem in Fig. 1 gezeigten Beispiel ist die Spule 2 in Form der an sich bekannten Helmholtz-Anordnung, also als Spulenpaar ausgestaltet. Der Innenraum dieser Spule 2 befindet sich zwischen den beiden Teilspulen 21 und 22 und wird weiterhin durch zwei in Fig. 1 gestrichelt gezeichnete Begrenzungslinien AO und AU begrenzt. Das RF-Feld B₁ ist im allgemeinen senkrecht zu dem externen Magnetfeld B₀ orientiert, wie dies durch den mit dem Bezugszeichen B₁ versehenen Pfeil in Fig. 1 symbolisch angedeutet ist.

Es versteht sich, dass mit dem Begriff "Spule" ganz allgemein Mittel gemeint sind, mit denen sich ein hochfrequentes elektromagnetisches Wechselfeld erzeugen lässt. Dies können beispielsweise auch folienartig ausgestaltete Mittel sein. Auch kann die Spule 2, wie dies z. B. in Fig. 1 dargestellt ist, aus mehr als einer Teilspule bestehen. Ferner kann die Spule oder jede der Teilspulen beispielsweise auch nur eine Windung aufweisen. Weiterhin ist es möglich, dass die Spule mehrere in- oder übereinander gewickelte Teilspulen umfasst. Auch solche Spulen sind vom Stand der Technik her bekannt und finden typischerweise z. B. in Doppel- oder Tripel-Resonanzuntersuchungen Anwendung, wenn in einem Experiment verschiedenen RF-Felder mit stark unterschiedlichen Frequenzen erzeugt werden sollen.

Wie in Fig. 1 gezeigt, reicht das Probenröhrchen 1 durch den Innenraum der Spule 2 hindurch. Das Probenröhrchen 1 ist von seinem abgerundeten Boden 11 beginnend soweit mit der Probe 4 aufgefüllt, dass die Probe bezüglich der z-Achse Z in beiden Richtungen deutlich über den durch die Begrenzungslinien AO und AU begrenzten Innenraum der Spule hinaus reicht. Wie bereits erwähnt, dient diese allgemein übliche Massnahme dazu, Sprünge oder abrupte Änderungen in der magnetischen Suszeptibilität zu vermeiden, die sich äusserst störend auf sie Signalqualität auswirken würden.

Als aktives Probenvolumen 4a wird derjenige Teil der Probe 4 bezeichnet, der sich im Innenraum der Spule 2 befindet. In Fig. 1 ist dies der gekreuzt schraffiert eingezeichnete Bereich zwischen den Teilspulen 21, 22 und den beiden Begrenzungslinien AO und AU, also der Teil der Probe 4, welcher von der Spule 2 umgeben wird.

Die bisher gemachten Erläuterungen beschreiben bekannten Stand der Technik.

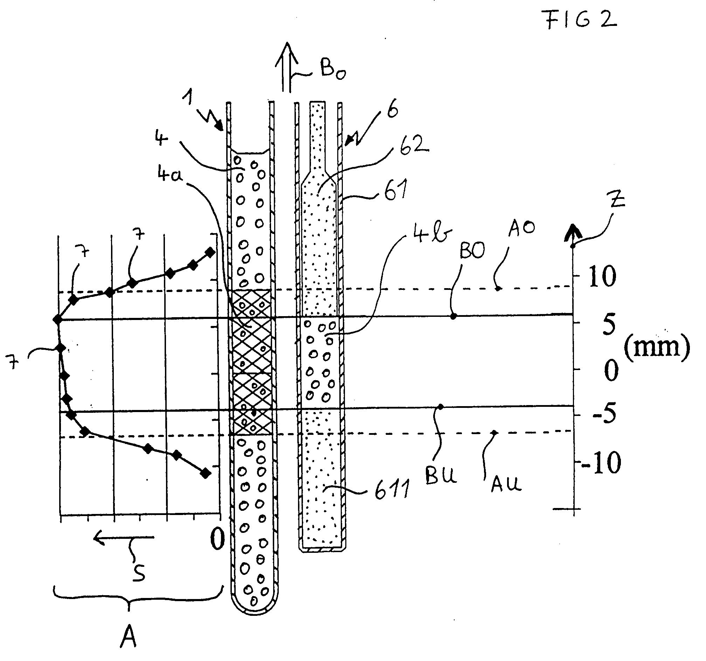

Erfindungsgemäss wird nun vorgeschlagen, dass das aktive Probenvolumen 4b (Fig. 2) kleiner gemacht wird als der Innenraum der Spule 2. Das erfindungsgemässe kernmagnetische Untersuchungsverfahren mittels Kernspinresonanz ist dadurch gekennzeichnet, dass von der Probe höchstens neunzig Prozent des Innenraums der Spule 2 besetzt werden und dass der Rest des Innenraums der Spule 2 mit einem Material gefüllt ist, dessen magnetische Suszeptibilität an die magnetische Suszeptibilität der Probe angepasst ist. Somit stellt erfindungsgemäss im wesentlichen die gesamte Probe das aktive Probenvolumen 4b dar.

Dadurch wird es erreicht, dass in den Randbereichen der Spule 2 bezüglich der z-Achse Z - dies sind die Bereiche des Innenraums der Spule 2 und des Aussenraums der Spule 2, welche an die in Fig. 1 eingezeichneten Begrenzungslinien AO,AU angrenzen - kein Probenmaterial vorhanden ist. Gerade in diesen Randbereichen ist aber der Abfall in der Stärke des RF-Feldes B₁ deutlich merkbar. Da dort erfindungsgemäss kein Probenmaterial vorhanden ist, resultiert eine deutliche Steigerung der räumlichen Homogenität des RF-Feldes B₁ über das gesamte aktive Probenvolumen 4b. Diese deutliche Verbesserung wird weiter hinten anhand zweier Beispiele dokumentiert. Da zudem erfindungsgemäss der nicht von der Probe besetzte Teil des Innenraums der Spule 2 mit einem Material ausgefüllt ist, dessen magnetische Suszeptibilität an die der Probe angepasst ist, werden auch solche Störeffekte, die auf starken Änderungen der magnetischen Suszeptibilität in den Randbereichen der Spule 2 basieren, vermieden. Aufgrund der deutlichen Verbesserung der räumlichen Homogenität des RF-Feldes B₁ über das aktive Probenvolumen 4b lassen sich mit dem erfindungsgemässen Verfahren zahlreiche NMR-Untersuchungen mit gesteigerter Empfindlichkeit und weitestgehend frei von Artefakten durchführen. Besonders vorteilhaft ist es, dass das erfindungsgemässe Verfahren besonders einfach ist und ohne zusätzlichen Zeitaufwand und instrumentellen Aufwand in handelsüblichen NMR-Spektrometern mit den üblichen Spulen durchführbar ist.

Das erfindungsgemässen Verfahren wird im folgenden unter Bezugnahme auf Fig. 2 anhand eines Ausführungsbeispiels noch detaillierter erläutert. Zum besseren Verständnis der Erfindung ist im linken Teil von Fig. 2 nochmals das Probenröhrchen 1 mit der Probe 4 und dem aktiven Probenvolumen 4a, wie es bereits in Fig. 1 dargestellt wurde, eingezeichnet. In der Grafik A links des Probenröhrchens 1 ist die Stärke des RF-Feldes B₁ für verschiedene Orte in der Spule 2 dargestellt. Die Stärke des RF-Feldes ist als Funktion der Koordinate auf der z-Achse Z dargestellt. Die z-Achse Z ist mit einer Millimeter-Skala versehen, deren Nullpunkt willkürlich gewählt ist. Die Stärke des RF-Feldes nimmt in Richtung des Pfeiles S zu. Der Nullpunkt 0 für die Stärke des RF-Feldes B₁ ist ebenfalls eingezeichnet. Die nicht eingezeichnete Spule 2 umgibt den gekreuzt schraffierten Bereich des Probenröhrchens 1. Die Bestimmung der Stärke des RF-Feldes B₁ für die verschiedenen Orte erfolgt mittels NMR-Messungen. Als Probe dient beispielsweise eine Mischung aus CHCl₃ und CDCl₃ im Volumenverhältnis 1 zu 4. Für die Bestimmung der Stärke des RF-Feldes B₁ an den verschiedenen Orten, die durch die Vierecke 7 dargestellt ist, wird beispielsweise die Resonanz des ¹H-Kerns verwendet. Qualitativ gleiche Kurven, wie die in der Graphik A von Fig. 2 dargestellte, ergeben sich natürlich auch aus der Resonanz andere Kerne, wie z. B. der ¹³C-Kernresonanz. Das genaue Verfahren wird weiter hinten erläutert. Im rechten Teil der Fig. 2 ist ein Probenbehälter 6 dargestellt, der beispielsweise für die Durchführung des erfindungsgemässen Verfahrens geeignet ist. Der Probenbehälter 6 ist zweiteilig ausgestaltet und umfasst einen röhrenförmigen äusseren Teil 61 mit einem Boden 611 sowie einen stempelartig ausgestalteten inneren Teil 62, welcher so in den röhrenförmigen äusseren Teil 61 eingeführt werden kann, dass zwischen dem Boden 611 des äusseren Teils 61 und dem stempelartigen inneren Teil 62 eine Kavität zur Aufnahme der Probe entsteht. Eine abgemessene Menge der Probe wird in den röhrenförmigen äusseren Teil 61 eingefüllt, und dann wird der stempelartige innere Teil 62 in den äusseren Teil 61 eingeführt, so dass das aktive Probenvolumen 4b zwischen dem Boden 611 und dem stempelartigen Teil 62 gebildet wird. Der Boden 611 des äusseren Teils 61 sowie der stempelartige innerer Teil 62 - die Teile, die in Fig. 2 gepunktet dargestellt sind - sind aus einem Material gefertigt, dessen magnetische Suszeptibilität an die der Probe angepasst ist. Für den in der hochauflösenden NMR häufig auftretenden Fall, dass die Probe aus einer Lösung in Wasser oder deuteriertem Wasser besteht, sind solche suszeptbilitätsangepassten Probenbehälter 6 kommerziell erhältlich. Sie werden beispielsweise von der Firma Shigemi Co., Ltd. (Hachioji-City, Tokyo, Japan) vertrieben und sind beispielsweise aus einem speziellen Typ von hartem Glas hergestellt, dessen magnetische Suszeptibilität an diejenige von deuteriertem Wasser angepasst ist. Vom Stand der Technik ist es bekannt, solche Probenbehälter zur Minimierung von Problemen mit der Homogenität des externen, statischen Magnetfeldes B₀ zu verwenden.

Wie aus der Graphik A in Fig. 2 ersichtlich, stimmt der Bereich grosser Stärke des RF-Feldes B₁ grob mit dem gekreuzt schraffierten Bereich des Probenröhrchens 1 überein, also mit dem Bereich des Probenröhrchens 1, welcher von der Spule 2 umgeben wird. Genauso deutlich ist aber auch ersichtlich, dass die Stärke des RF-Feldes B₁ an den Begrenzungslinien AO, AU, also am Rand der Spule 2, bereits signifikant abgefallen ist und nur noch etwa 70% des maximalen Wertes aufweist. Das bedeutet, dass die Kernspins in diesen Randbereichen nur noch um einen Winkel gedreht werden, der deutlich kleiner ist als der nominelle Wert des RF-Impulses. Noch drastischer wird dieser Effekt ausserhalb des aktiven Probenvolumens 4a. Hier existieren beispielsweise Probenbereiche, in denen die Stärke des RF-Feldes B₁ nur noch die Hälfte ihres maximalen Wertes besitzt. Das bedeutet aber, dass beispielsweise ein nomineller 180°-Impuls für diese Probenbereiche nur noch einen 90°-Impuls darstellt. Solche Effekte sind eine hauptsächliche Quelle für Artefakte.

Bei dem erfindungsgemässen Verfahren werden diese äusserst störenden Effekte weitestgehend vermieden, ohne dass dafür eine andere Spule vonnöten wäre. Wie aus der Darstellung des Probenbehälters 6 in Fig. 2 ersichtlich, befindet sich die gesamte Probe, die erfindungsgemäss mit dem aktiven Probenvolumen 4b räumlich übereinstimmt, nur noch in dem Bereich der Spule 2, in dem die Stärke des RF-Feldes B₁ in sehr guter Näherung räumlich konstant ist. Dieser Bereich ist der in Fig. 2 durch die Linien BO und BU begrenzte. Mithin erfahren im wesentlichen die Kernspins in allen Bereichen des aktiven Probenvolumens 4b einen Drehwinkel, der dem nominellen Wert des RF-Impulses entspricht. Dadurch werden die vorne beschriebenen Artefakte weitestgehend vermieden und durch die effizientere, weil räumlich homogenere, Anregung wird gleichzeitig eine äusserst vorteilhafte Steigerung der Empfindlichkeit von NMR-Untersuchungen erzielt.

Aus der Graphik A ist ersichtlich, dass die räumliche Homogenität des RF-Feldes B₁ über das aktive Probenvolumen 4b um so besser wird, je kleiner das aktive Probenvolumen 4b gemacht wird. Andererseits ist aber zu berücksichtigen, dass eine Verkleinerung des Probenvolumens auch mit einem Verlust in der Signalintensität einhergehen kann. Deshalb muss das optimale aktive Probenvolumen unter Berücksichtigung dieser beiden Aspekte sorgfältig bestimmt werden. In der Praxis zeigt es sich, dass sich eine sehr gute räumliche Homogenität des RF-Feldes B₁ über das gesamte aktive Probenvolumen 4b und gleichzeitig eine sehr gute Signalintensität erzielen lässt, wenn die Probe höchstens achtzig Prozent und insbesondere weniger als siebzig Prozent des Innenraums der Spule 2 besetzt. Mit den heute in der hochauflösenden NMR üblichen Spulen entspricht dies in absoluten Zahlen einem Volumen der Probe von höchstens zweihundert und insbesondere weniger als einhundertsiebzig Mikrolitern. Solche Probenvolumina werden deshalb für das erfindungsgemässe Verfahren besonders bevorzugt.

Ebenfalls unter dem Aspekt einer optimalen räumlichen Homogenität des RF-Feldes B₁ über das aktive Probenvolumen wird die Probe bevorzugt bezüglich des Innenraums der Spule zentriert in diesen eingebracht.

Um die deutlichen Verbesserungen zu dokumentieren, die durch das erfindungsgemässe Verfahren erzielt werden, werden im folgenden noch zwei Beispiele von NMR-Mesungen erläutert, die einen Vergleich des erfindungsgemässen Verfahrens mit vom Stand der Technik her bekannten beinhalten. Die Messungen werden jeweils mit dem vorne erwähnten NMR-Spektrometer 600 MHz UnityPlus von der Firma Varian in einem Magnetsystem vom Typ Oxford 600/51 durchgeführt.

### Beispiel 1

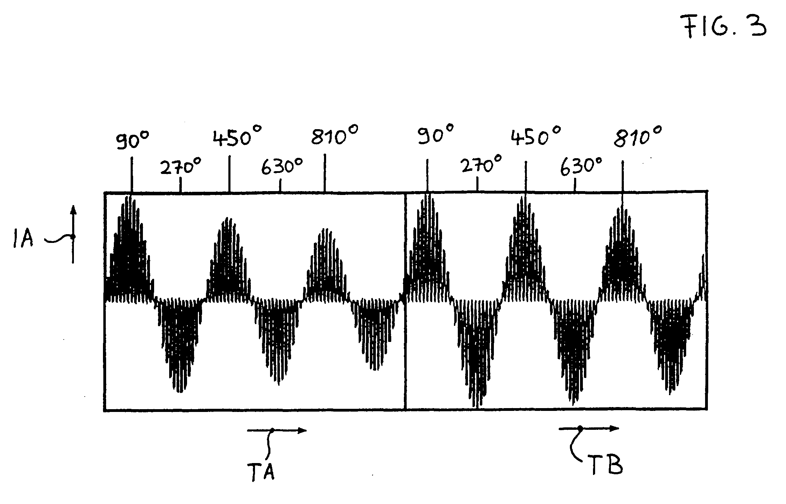

Es werden zwei Proben präpariert aus 20 mM (mmol/l) Glucose, die in deuteriertem Wasser (D₂O) gelöst wird. 95% der Glucose sind zu 98% mit dem Kohlenstoffisotop ¹³C angereichert. 5% der Glucose haben ihre natürliche Isotopenhäufigkeit. Von 800 µl dieser Lösung werden 650 µl in ein Probenröhrchen vom Typ XXA-5-LP 8 '' der Firma Camparo Scientific (AH Veenendaal, Niederlande) eingefüllt. Diese Konfiguration entspricht der in Fig. 1 bzw. im linken Teil von Fig. 2 dargestellten. 150 µl der Lösung werden in einen suszeptibilitätsangepassten Probenbehälter vom Typ BMS-005V der Firma Shigemi eingefüllt. Diese Konfiguration entspricht der im rechten Teil von Fig. 2 dargestellten, welche mit dem Bezugszeichen 6 versehen ist. Das Probenröhrchen und der Probenbehälter haben den gleichen Innendurchmesser. Die Messungen an den beiden Proben werden in derselben Spule durchgeführt. Zunächst wird die 650 µl-Probe in die Spule und mit dieser in das externe Magnetfeld B₀ eingebracht und das Protonen-NMR-Spektrum nach einem einfachen RF-Impuls aufgenommen. In der Folge wird bei konstant gehaltener Amplitude, d.h. Stärke, des RF-Feldes B₁ die Zeitdauer des RF-Impulses sukzessive erhöht und jeweils das Protonen-NMR-Spektrum aufgenommen. Aus einer solchen Messreihe ergibt sich die Intensität des Protonen-NMR-Signals als Funktion der Zeitdauer des RF-Impulses. Letztere ist proportional zu dem Drehwinkel der Kernmagnetisierung, den der RF-Impuls verursacht. Im linken Teil der Fig. 3 ist das Ergebnis einer solchen Messreihe graphisch dargestellt. Der Pfeil TA zeigt in Richtung zunehmender Zeitdauer des RF-Impulses, der Pfeil IA in Richtung zunehmender Intensität des Protonen-NMR-Signals. Die durch den RF-Impuls verursachten Drehwinkel sind in dieser Graphik ebenfalls angegeben. Das erste nach oben gerichtete Maximum tritt für einen Drehwinkel von 90° auf (90°-Impuls), das zweite für einen Drehwinkel von 450°, das dritte für einen Drehwinkel von 810°. Ein Drehwinkel von 810° (810°-Impuls) bedeutet, dass die Magnetisierung zwei vollständige und eine Viertelumdrehung um eine zur z-Achse senkrechte Achse vollführt hat. Eine analoge Messreihe wird nun mit der 150 µl-Probe durchgeführt. Das Ergebnis ist in der Graphik im rechten Teil der Fig. 3 dargestellt. Der Pfeil TB zeigt wiederum in Richtung zunehmender Zeitdauer des RF-Impulses. Als Mass für die räumliche Homogenität des RF-Feldes über das aktive Probenvolumen dient die Signalintensität nach dem 810°-Impuls verglichen mit der Signalintensität nach dem 90°-Impuls. Für die 650 µl-Probe beträgt die Signalintensität nach dem 810°-Impuls nur noch 69% der Signalintensität nach dem 90°-Impuls. Dies ist ein typischer Wert, wie er sich mit Verfahren, die zum Stand der Technik gehören, erreichen lässt. Für die 150 µl-Probe beträgt die Signalintensität nach dem 810°-Impuls deutlich mehr, nämlich noch 89% der Intensität nach dem 90°-Impuls. Dieser Vergleich demonstriert eindrücklich die signifikanten Verbesserungen in der Homogenität des RF-Feldes über das aktive Probenvolumen, die sich mit dem erfindungsgemässen Verfahren erreichen lassen.

### Beispiel 2

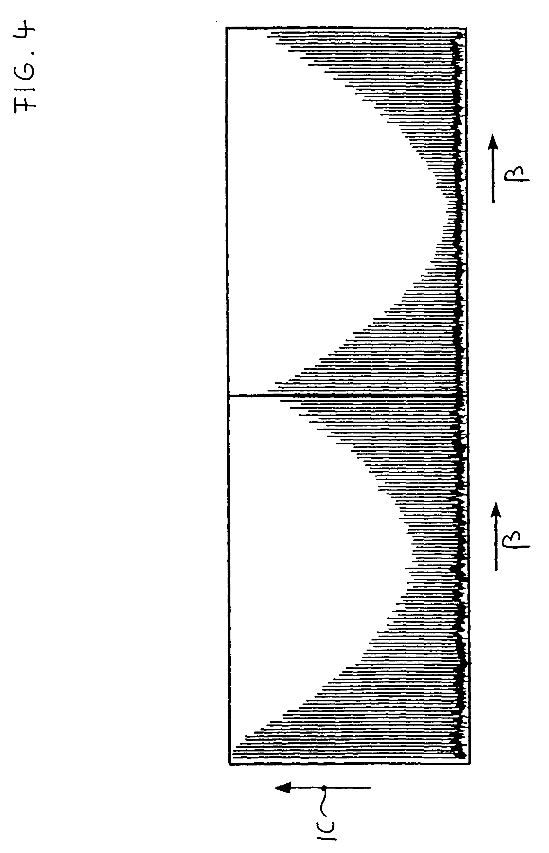

In den gleichen beiden Proben wie in Beispiel 1 wird der Drehwinkel für die ¹³C-Kernspins indirekt gemessen, indem die an sich bekannte eindimensionale Version einer Impulsfolge angewendet wird, die zum Typ der heteronuklearen Multi-Quanten-Kohärenz (HMQC) Impulsfolgen gehört. Die Zeitdauer β (Fig. 4) des RF-Impulses, welcher die ¹³C-Kernspins anregt, wird sukzessive erhöht. In Fig. 4 ist die Intensität des Protonensignals, zunehmend in Richtung des Pfeils IC, als Funktion der Zeitdauer β des RF-Impulses, welcher die ¹³C-Kernspins anregt, dargestellt. Die Zeitdauer β nimmt in Richtung des Pfeils zu. Die linke Graphik in Fig. 4 zeigt das Ergebnis für die 650 µl-Probe, die rechte Graphik das Ergebnis für die 150 µl-Probe. Wenn die Zeitdauer β einen Wert erreicht, der einem 180°-Impuls für die ¹³C-Kernspins entspricht, sollte die Intensität des Protonensignals theoretisch verschwinden. Die linke Graphik in Fig. 4 zeigt, dass im Bereich des Minimums der Signalintensität noch ein deutliches Signal zu beobachten ist. Dies ist hauptsächlich darauf zurückzuführen, dass aufgrund der Inhomogenität des RF-Feldes in der 650 µl-Probe ein nomineller 180°-Impuls nicht für alle Bereiche der Probe, die zum Signal beitragen, einen 180°-Impuls darstellt. Die rechte Graphik demonstriert deutlich die Verbesserungen, die sich mit dem erfindungsgemässen Verfahren erzielen lassen.

Das erfindungsgemässe Verfahren eignet sich insbesondere auch, um die räumliche Homogenität des von der Spule erzeugten hochfrequenten elektromagnetischen Wechselfeldes zu messen. Dazu wird eine Probe, die höchstens zwanzig Prozent. insbesondere weniger als zehn Prozent des Innenraums der Spule 2 besetzt, beispielsweise in den Probenbehälter 6, wie er in Fig. 2 dargestellt ist, eingebracht, und an verschiedene Orte des Innenraums der Spule 2 plaziert. Als Mass für die Stärke des hochfrequenten elektromagnetischen Wechselfeldes an dem jeweiligen Ort im Innenraum der Spule kann beispielsweise die reziproke Zeitdauer eines 360°-Impulses dienen. Diese Zeitdauer lässt sich beispielsweise bestimmen, indem sukzessive die Zeitdauer des RF-Impulses bei konstant gehaltener Stärke des RF-Feldes B₁ erhöht wird. Verschwindet das NMR-Signal zum ersten Mal, so entspricht die zugehörige Zeitdauer einem 180°-Impuls, verschwindet dann mit zunehmender Zeitdauer des RF-Impulses das Signal zum zweiten Mal, so entspricht die zugehörige Zeitdauer einem 360°-Impuls. In den Graphiken in Fig. 3 entspricht beispielsweise jeweils die Zeitdauer einem 360°-Impuls, bei welcher der zweite Nulldurchgang der Signalintensität auftritt. Mit diesem Verfahren lässt sich beispielsweise die Stärke des RF-Feldes, wie sie in der Graphik A von Fig. 2 dargestellt ist, bestimmen. Ein Probenvolumen von 25 µl wird in den Probenbehälter 6 eingebracht und der Probenbehälter 6 in verschiedene Positionen bezüglich der z-Achse Z plaziert, so dass sich die Probe an verschiedenen Orten des Innenraums der Spule 2 befindet. Für jeden dieser Orte wird dann die Stärke des RF-Feldes B₁ bestimmt.

Aufgrund seiner Einfachheit und seiner Durchführbarkeit in üblichen NMR-Spektrometern eignet sich das erfindungsgemässe Verfahren für eine grosse Anzahl von hochauflösenden NMR-Untersuchungen. Besonders geeignet ist das erfindungsgemässe Verfahren auch für Proben, die Biomoleküle, wie beispielsweise Proteine, Nukleinsäuren und Kohlehydrate enthalten. Die Untersuchung solcher Proben erfolgt normalerweise mit äusserst umfangreichen RF-Impulsfolgen, die typischerweise eine sehr grosse Anzahl von Impulsen umfassen. Dabei ist es ein für die Empfindlichkeit der Messung ganz entscheidender Faktor, dass im gesamten zum Signal beitragenden Probenvolumen die erzielten Drehwinkel für jeden RF-Impuls möglichst genau mit den nominellen Drehwinkeln übereinstimmen, d. h. dass beispielsweise ein 90°-Impuls im gesamten zum Signal beitragenden Probenvolumen einen Drehwinkel von 90° verursacht. Diesbezüglich lassen sich mit dem erfindungsgemässen Verfahren signifikante Verbesserungen erzielen.

Gerade im Hinblick auf hochauflösende NMR-Untersuchungen soll betont werden, dass sich das erfindungsgemässe Verfahren insbesondere auch vorteilhaft mit Proben in Form einer Lösung in Wasser oder deuteriertem Wasser durchführen lässt. Dafür wird die Probe bevorzugt in einen Probenbehälter 6 eingebracht, der aus einem Material, z. B. einem speziellen Typ von hartem Glas, hergestellt wird, dessen magnetische Suszeptibilität an die von deuteriertem Wasser angepasst ist.

In nicht abschliessender Aufzählung seien hier noch einige Arten von NMR-Untersuchungen bzw. Impulsfolgen erwähnt, für die sich das erfindungsgemässe Verfahren eignet: ein- und mehrdimensionale NMR; Single-Resonance-Verfahren wie Korrelationsspektroskopie (COSY), totale Korrelationsspektroskopie (TOCSY), Nuclear Overhauser Enhancement Spectroscopy (NOESY); Doppel-Resonanz-Verfahren wie heteronukleare Multi-Quanten-Kohärenz (HMQC), heteronukleare Ein-Quanten-Kohärenz (HSQC); Halb- und Doppelhalbfilter Untersuchungen; Tripel-Resonanz-Verfahren.

Das erfindungsgemässe Verfahren bringt noch einen weiteren Vorteil für die Entwicklung neuer Spulen mit sich. Da in den Randbereichen der Spule keine Probe mehr vorhanden ist, braucht man sich in Zukunft nicht mehr darauf zu konzentrieren, dass das RF-Feld am Rand der Spule möglichst steil auf Null abfällt. Dieser steile Abfall, dem bei heute bekannten Spulenkonstruktionen eine wesentliche Bedeutung zukommt, ist bei dem erfindungsgemässen Verfahren praktischnicht mehr vonnöten. Deshalb kann man sich bei der Konstruktion bzw. dem Design neuer Spulen im wesentlichen auf den Aspekt konzentrieren, eine möglichst gute räumliche Homogenität des RF-Feldes über das aktive Probenvolumen zu erzielen.

Das erfindungsgemässe Verfahren bietet somit die Möglichkeit, eine Vielzahl von NMR-Untersuchungen mit einer deutlich gesteigerten räumlichen Homogenität des RF-Feldes über das gesamte aktive Probenvolumen durchzuführen. Somit werden Artefakte weitestgehend vermieden und die Empfindlichkeit der Messungen gesteigert, ohne dass dafür ein wesentlicher zusätzlicher instrumenteller oder zeitlicher Aufwand vonnöten ist.

## Patentansprüche

1. Kernmagnetisches Untersuchungsverfahren mittels Kernspinresonanz, bei welchem eine zu untersuchende Probe in den Innenraum einer Spule (2) eingebracht wird, so dass zumindest Teile der Probe von der Spule (2) umgeben werden und somit ein aktives Probenvolumen (4a;4b) bilden; bei welchem die Probe in ein externes Magnetfeld (B₀) eingebracht wird; und bei welchem Kernspins von in der Probe enthaltenen Atomkernen durch ein von der Spule (2) erzeugtes hochfrequentes elektromagnetisches Wechselfeld (B₁) zu kernmagnetischer Resonanz angeregt werden, dadurch gekennzeichnet, dass von der Probe höchstens neunzig Prozent des Innenraums der Spule (2) besetzt werden, und dass der Rest des Innenraums der Spule (2) mit einem Material gefüllt wird, dessen magnetische Suszeptibilität an die magnetische Suszeptibilität der Probe angepasst ist.

2. Verfahren nach Anspruch 1, dadurch gekennzeichnet, dass von der Probe höchstens achtzig Prozent und insbesondere weniger als siebzig Prozent des Innenraums der Spule (2) besetzt werden.

3. Verfahren nach Anspruch 1, dadurch gekennzeichnet, dass von der Probe höchstens zweihundert Mikroliter, insbesondere weniger als hundertsiebzig Mikroliter, des Innenraums der Spule (2) besetzt werden.

4. Verfahren nach einem der vorangehenden Ansprüche, dadurch gekennzeichnet, dass die Probe bezüglich des Innenraums der Spule (2) zentriert in diesen eingebracht wird.

5. Verfahren nach einem der vorangehenden Ansprüche, dadurch gekennzeichnet, dass die Probe in einen Probenbehälter (6) eingebracht wird und der Probenbehälter (6) in den Innenraum der Spule (2) eingesetzt wird.

6. Verfahren nach Anspruch 5, dadurch gekennzeichnet, dass die Probe in einen zweiteiligen Probenbehälter (6) eingebracht wird, welcher einen röhrenförmigen äusseren Teil (61) mit einem Boden (611) aufweist, sowie einen stempelartig ausgestalteten inneren Teil (62), welcher so in den röhrenförmigen äusseren Teil (61) eingeführt werden kann, dass zwischen dem Boden (611) des äusseren Teils (61) und dem stempelartigen inneren Teil (62) eine Kavität zur Aufnahme der Probe entsteht.

7. Verfahren nach einem der Ansprüche 5 oder 6, dadurch gekennzeichnet, dass die Probe als eine Lösung in Wasser oder deuteriertem Wasser in den Probenbehälter (6) eingebracht wird.

8. Verfahren nach Anspruch 7, dadurch gekennzeichnet, dass der Probenbehälter (6), in den die Probe eingebracht wird, aus einem Material hergestellt wird, dessen magnetische Suszeptibilität an die magnetische Suszeptibilität von deuteriertem Wasser angepasst ist.

9. Verfahren nach einem der vorangehenden Ansprüche, dadurch gekennzeichnet, dass die Probe Biomoleküle, insbesondere Proteine, Nukleinsäuren, Kohlehydrate, enthält.

10. Verfahren nach Anspruch 1, dadurch gekennzeichnet, dass zur Messung der räumlichen Homogenität des von der Spule (2) erzeugten hochfrequenten elektromagnetischen Wechselfeldes (B₁) eine Probe, durch welche höchstens zwanzig Prozent, insbesondere weniger als zehn Prozent, des Innenraums der Spule (2) besetzt werden, an verschiedene Orte des Innenraums der Spule (2) plaziert wird und jeweils die Stärke des hochfrequenten elektromagnetischen Wechselfeldes (B₁) an diesem Ort bestimmt wird.

11. Verfahren nach Anspruch 10, dadurch gekennzeichnet, dass als Mass für die Stärke des hochfrequenten elektromagnetischen Wechselfeldes (B₁) an dem jeweiligen Ort jeweils die reziproke Zeitdauer eines 360°-Impulses verwendet wird.
